# EUROPÄISCHE PATENTSCHRIFT

(11) **EP 0 698 917 B1**
(45) Veröffentlichungstag und Bekanntmachung des Hinweises auf die Patenterteilung: **09.06.1999**
(21) Anmeldenummer: 95113289.3
(22) Anmeldetag: 24.08.1995
(51) Int. Cl.: H01L 21/306, C11D 3/20

(54) **Verfahren zum Reinigen von Halbleiterscheiben**
Process for cleaning semiconductor wafers
Procédé pour le nettoyage des plaquettes de semi-conducteurs

(30) Priorität: 25.08.1994 DE 4430217; 24.04.1995 DE 19515024
(43) Veröffentlichungstag der Anmeldung: 28.02.1996
(73) Patentinhaber: Wacker Siltronic Gesellschaft für Halbleitermaterialien Aktiengesellschaft, 84489 Burghausen (DE)
(72) Erfinder: Brunner, Roland, D-84367 Reut (DE); Hochgesang, Georg, D-84489 Burghausen (DE); Schnegg, Anton, Dr., D-84489 Burghausen (DE); Thalhammer, Gertraud, D-84489 Burghausen (DE)
(74) Vertreter: Rimböck, Karl-Heinz, Dr.

(56) Entgegenhaltungen:
- EP-A- 0 095 171
- DE-A- 4 209 865
- US-A- 4 009 299
- DATABASE WPI Section Ch, Week 8451 Derwent Publications Ltd., London, GB; Class A85, AN 84-314862 & JP-A-59 196 385 ( SHINKO DENKI KK) , 7.November 1984

## Beschreibung

Die Erfindung betrifft ein Verfahren zum Reinigen von Halbleiterscheiben. Ziel des Verfahrens ist es, Verunreinigungen von der Scheibenoberfläche zu entfernen. Unter dem Begriff Verunreinigungen sind vor allem Fremdmetalle, organische Verbindungen und Partikel mit Durchmessern im Bereich von weniger als 1 µm zu verstehen.

Eine seit langem bekannte und oft verwendete Reinigungs-Methode ist die sogenannte RCA-Reinigung (W.Kern, D.A. Puotinen, RCA Review, vol.31, p.187-206 (1970)). Fester Bestandteil dieses Verfahrens sind zwei Reinigungsbäder, in denen die Halbleiterscheiben zunächst mit einer als SC1-Lösung bezeichneten, wässerigen Flüssigkeit und dann mit einer als SC2-Lösung bezeichneten, wässerigen Flüssigkeit behandelt werden. Während es sich bei der SC1-Lösung um eine Lösung von Wasserstoffperoxid und Ammoniumhydroxid handelt, deren oxidativ-alkalische Beschaffenheit für die Entfernung von Partikeln und organischen Rückständen verantwortlich ist, werden mit der auf verdünnter Salzsäure und Wasserstoffperoxid basierenden SC2-Lösung hauptsächlich Fremdmetalle von den Oberflächen der behandelten Halbleiterscheiben entfernt. Nachteilig an der zweistufigen RCA-Reinigung ist, daß die SC1-Lösung die Oberflächen von Halbleiterscheiben zwar weitgehend von Partikeln befreit, gleichzeitig aber eine zusätzliche Quelle für die Verunreinigung der Halbleiterscheiben mit Fremdmetallen wie Eisen, Zink und Aluminium ist. Ebenso wird zwar durch die anschließende Behandlung mit SC2-Lösung die meßbare Konzentration an Fremdmetallen auf den Scheibenoberflächen deutlich verringert, jedoch steigt durch diese Behandlung die Zahl der auf den Scheibenoberflächen haftenden Partikel wieder an (P.H.Singer in Semiconductor International, p.36-39 (Dec.1992)).

Verschiedene Verfahren zum Reinigen von Halbleiterscheiben unterstützen das Entfernen von Verunreinigungen dadurch, daß Energie, beispielsweise in Form von Schallwellen ("Megasonic- und Ultrasonic-Reinigung") (oder in Form von kinetischer Energie ("Scrubber-Verfahren")) in ein Reinigungsbad mit Halbleiterscheiben eingetragen wird. Bei den sogenannten "Scrubber-Verfahren" wird beispielsweise über Walzenstöcke auf den Seitenflächen von Halbleiterscheiben ein stark strömender Reinigungsmittel-Film erzeugt, der sehr wirksam oberflächlich anhaftende Partikel abzulösen vermag (W.C.Krusell, D.I.Golland, Proc.Electrochem.Soc., p.23-32 (1990)).

Das Dokument "Database WPI, Section Ch,Week 8451, Derwent Publication Ltd., London, GB Class A 85, AN 84-314862 and JP-A-59196385" beschreibt ein Verfahren zum Entfernen von Metaloxidfilmen von einem Kappenförmigen Gegenstand mit Hilfe von Bernsteinsäure und Tensiden. DE-A-42 09 865 offenbart ein Verfahren zum Reinigen von Halbleiterscheiden mit Hilfe einer Lösung von Oxalsäure und Tensiden.

Die Aufgabe der vorliegenden Erfindung bestand darin, ein Reinigungsmittel und ein Verfahren zum Reinigen von Halbleiterscheiben anzugeben, die geeignet sind, Verunreinigungen auf den Oberflächen von Halbleiterscheiben wirksam zu entfernen.

Gelöst wird die Aufgabe durch das Verfahren nach den Ansprüchen 1-3.

Das Verfahren ist besonders zum Reinigen von Halbleiterscheiben aus Silicium geeignet.

Halbleiterscheiben müssen im Verlauf ihrer Herstellung mehrmals gereinigt werden. Üblicherweise wird jede mechanische oder chemische Behandlung der Scheibenoberflächen mit einem Reinigungsschritt abgeschlossen. Beispielsweise ist nach dem Läppen eine Scheibenreinigung ebenso notwendig, wie nach dem chemischen Ätzen oder nach dem Polieren. Die eingangs erwähnte RCA-Reinigung dient meistens zum Reinigen von polierten Halbleiterscheiben. Prinzipiell kann jeder im Verlauf der Herstellung von Halbleiterscheiben fällige Reinigungsschritt mit einem Reinigungsmittel der vorliegenden Erfindung durchgeführt werden. Bevorzugt ist es jedoch, das Reinigungsmittel zum Reinigen von polierten Halbleiterscheiben einzusetzen. Besonders gute Reinigungsergebnisse lassen sich erzielen, wenn polierte Halbleiterscheiben mit einer SC1-Lösung oder einer SC1-Lösung und einer SC2-Lösung vorbehandelt und mit dem erfindungsgemäßen Reinigungsmittel nachgereinigt werden.

Die Halbleiterscheiben können zum Reinigen in ein Bad des Reinigungsmittels getaucht werden. Bevorzugt ist jedoch, die Reinigung der Halbleiterscheiben durch Zuführung von kinetischer Energie zum Reinigungsmittel zu unterstützen. Besonders bevorzugt ist es, dazu das "Scrubber-Verfahren" zu verwenden oder in Gegenwart des Reinigungsmittels eine oder mehreren Walzen aus Kunststoff parallel zur Scheibenseitenfläche zu bewegen. Die Halbleiterscheibe wird mechanisch nicht beansprucht, wenn das Tuch das Reinigungsmittel zu einem dünnen, über die Scheibenseitenfläche strömenden Film verteilt.

Das Reinigungsmittel enthält neben Wasser mindestens ein Tensid und mindestens eine Verbindung einer Gruppe von Verbindungen, die Bernsteinsäure und deren Derivate umfaßt. Ferner weist das Reinigungsmittel einen pH-Wert von 1 bis 5, vorzugsweise pH 1 bis 3 auf. Gegebenenfalls ist auch Salzsäure im Reinigungsmittel enthalten. Die Salzsäure kann beispielsweise verwendet werden, um den pH-Wert des Reinigungsmittels einzustellen.

Der Tensid-Anteil im Reinigungsmittel beträgt bevorzugt 0,01 bis 1 Gew.-%. Besonders bevorzugt sind Reinigungsmittel, die 0,01 bis 0,1 Gew.-% Tensid enthalten. Als Tenside können Einzelverbindungen oder Tensidgemische verwendet werden. Bevorzugt sind anionische, amphotere oder nichtionische Tenside, die in wässeriger Lösung einen neutralen oder schwach sauren pH-Wert erzeugen. Besonders bevorzugte Tenside sind Alkylphenoloxethylate sowie Alkylpolyglykolethersulfate.

Das Reinigungsmittel enthält eine oder mehrere Verbindungen aus einer Gruppe von Verbindungen, zu der Bernsteinsäure und deren Derivate gehören. Besonders zu erwähnende Mitglieder dieser Gruppe sind Bernsteinsäure, Sulfobernsteinsäure und deren Mono- und Diesterderivate. Besonders bevorzugt werden Bernsteinsäure (HOOCCH₂CH₂COOH) und/oder Sulfobernsteinsäure (HOOCCH₂CH(SO₃H)COOH) verwendet. Die Konzentration dieses Bestandteils des Reinigungsmittels beträgt vorzugsweise insgesamt 0,001 bis 1,0 Gew.-%, besonders bevorzugt 0,01 bis 0,1 Gew.-%.

Gegebenenfalls kann das Reinigungsmittel eine weitere Stoffkomponente enthalten, die metallkomplexbildende Eigenschaften aufweist. Eriochromschwarz T und/oder Ferritin eignen sich dafür besonders gut.

Die Leistungsfähigkeit des Reinigungsmittels wird in der nachfolgenden Gegenüberstellung an Beispielen demonstriert: Fünfzig polierte Siliciumscheiben mit einem Durchmesser von 150 mm wurden zunächst einer üblichen RCA-Reinigung unterworfen. Bei der Hälfte dieser Scheiben wurde anschließend deren Oberflächen auf Verunreinigungen untersucht (Vergleichsbeispiele 1 und 2). Die andere Hälfte der Scheiben wurde mit Reinigungsmitteln gemäß der Erfindung nachgereinigt. Das wässerige Reinigungsmittel gemäß Beispiel 1 enthielt 0,05 Gew.-% Nonylphenol-Ethylenoxid-Addukt, 0,05 Gew.-% Sulfobernsteinsäure und war mit konzentrierter Salzsäure (0,01 Gew.-%) auf einen pH-Wert von pH 2 eingestellt worden. Das wässerige Reinigungsmittel gemäß Beispiel 2 wies einen pH-Wert von pH 2 auf und enthielt 0,03 Gew.-% Nonylphenol-Ethylenoxid-Addukt und 0,5 Gew.-% Sulfobernsteinsäure, jedoch keine Salzsäure.

Das Nachreinigen der Siliciumscheiben wurde im üblichen "Scrubber-Verfahren" durchgeführt. Anschließend wurde auch bei diesen Scheiben der restliche Verunreinigungspegel gemessen (Beispiele 1 und 2).

Zur Analytik der Partikel wurde ein handelsüblicher Partikelzähler verwendet. Mit diesem Meßgerät wurden die Partikel gezählt und in Abhängigkeit ihres mittleren Durchmessers in drei Sorten eingeteilt. Der Nachweis von Fremdmetallen auf der Oberfläche der Siliciumscheiben erfolgte durch VPD/TXRF-Meßung (vapor phase decomposition/total reflexion X-ray fluorescence), mit Ausnahme der Metalle Natrium und Aluminium, die mit VPD/AAS (vapor phase decomposition/atomic absorption spectroscopy) gemessen wurden.

Die Ergebnisse der Messungen sind in den folgenden Tabellen zusammengefaßt:

| a) Partikel-Messung: | | | |
|---|---|---|---|
| | 0,1µm*) | 0,2µm*) | 0,3µm*) |
| Vergleichsbeispiel 1 | 564**) | 79**) | 6,2**) |
| | | | |
| Beispiel 1 | 525**) | 72**) | 4,2**) |
| | | | |
| Vergleichsbeispiel 2 | 40**) | 5**) | 4,0**) |
| | | | |
| Beispiel 2 | 40**) | 4,0**) | 4,0**) |

| | | | |
|---|---|---|---|
| *) Partikelgrößen, in drei Bereiche gegliedert: < 0,1µm; von 0,1 bis < 0,2µm; von 0,2 bis < 0,3µm | | | |
| **) mittlere Anzahl der gefundenen Partikel je Scheibe | | | |

| b) Fremdmetall-Messung***): | | | | |
|---|---|---|---|---|
| | K | Ca | Fe | Ni |
| Vergleichsbeispiel 1 | 1*10⁹ | 1*10⁹ | 1*10⁹ | 1*10⁹ |
| | | | | |
| Beispiel 1 | <1*10⁸ | <1*10⁸ | <1*10⁸ | <1*10⁸ |
| | | | | |
| Vergleichsbeispiel 2****) | <1*10¹⁰ | 1*10¹⁰ | 3*10⁹ | <1*10⁹ |
| | | | | |
| Beispiel 2****) | <1*10¹⁰ | <8,5*10⁹ | <1*10⁹ | <1*10⁹ |

| | Cu | Zn | Al | Na |
|---|---|---|---|---|
| Vergleichsbeispiel 1 | 3*10⁹ | 4*10⁹ | 8*10¹⁰ | 3*10¹⁰ |
| Beispiel 1 | <1*10⁸ | 3*10⁸ | 2*10¹⁰ | <2,2*10¹⁰ |
| Vergleichsbeispiel 2****) | 8*10⁹ | 1*10¹⁰ | 2,5*10¹⁰ | 2,4*10¹⁰ |
| Beispiel 2****) | 6*10⁹ | <1*10⁹ | <1,4*10¹⁰ | 3*10¹⁰ |

| | | | | |
|---|---|---|---|---|
| ***) alle Zahlenangaben haben die Einheit [Atome/cm²] und sind arithmetische Mittelwerte der Resultate der Messungen an den Scheiben einer Versuchsreihe. | | | | |
| ****) apparative Nachweisgrenze gegenüber Vergleichsbeispiel 1 und Beispiel 1 geändert. | | | | |

## Patentansprüche

1. Verfahren zum Reinigen von Halbleiterscheiben von Fremdmetallen und Partikeln mit einem mindestens ein Tensid und mindestens eine weitere Verbindung enthaltenden Reinigungsmittel, dadurch gekennzeichnet, daß auf den Seitenflächen der Halbleiterscheiben ein Reinigungsmittelfilm erzeugt wird, wobei das Reinigungsmittel einen pH von 1 bis 5 aufweist, und das Tensid aus einer Gruppe ausgewählt ist, die anionische, amphotere, nichtionische Tenside und deren Mischungen umfaßt, und die weitere Verbindung aus einer Gruppe ausgewählt ist, die Bernsteinsäure und Sulfobernsteinsäure, deren Mono- und Diesterderivate und Mischungen der genannten Stoffe umfaßt.

2. Verfahren nach Anspruch 1, dadurch gekennzeichnet, daß der Film mit Hilfe eines mechanischen Werkzeuges erzeugt wird.

3. Verfahren nach Anspruch 1 oder Anspruch 2, dadurch gekennzeichnet, daß Salzsäure ein weiterer Bestandteil des Reinigungsmittels ist.

## Claims

1. Method for cleaning semiconductor wafers to remove foreign metals and particles, using a cleaning agent comprising at least one surfactant and at least one further compound, characterized in that a film of cleaning agent is generated on the side faces of the semiconductor wafers, the cleaning agent having a pH of from 1 to 5 and the surfactant being selected from a group embracing anionic, amphoteric and nonionic surfactants and mixtures thereof and the further compound being selected from a group embracing succinic and sulphosuccinic acid, their mono- and diester derivatives, and mixtures of the said substances.

2. Method according to Claim 1, characterized in that the film is generated with the aid of a mechanical tool.

3. Method according to Claim 1 or Claim 2, characterized in that hydrochloric acid is a further constituent of the cleaning agent.

## Revendications

1. Procédé de nettoyage de plaquettes de semiconducteurs en vue d'éliminer les métaux étrangers et les particules, à l'aide d'un agent nettoyant contenant au moins un tensio-actif et au moins un composé supplémentaire, caractérisé en ce qu'un film d'agent nettoyant est généré sur les faces latérales des plaquettes de semi-conducteurs, l'agent nettoyant présentant un pH de 1 à 5, et le tensio-actif étant choisi parmi un groupe constitué des tensio-actifs anioniques, amphotères, non ioniques et de leurs mélanges, et le composé supplémentaire étant choisi parmi un groupe constitué de l'acide succinique et de l'acide sulfosuccinique, de leurs dérivés mono- et diesters et de mélanges desdites substances.

2. Procédé selon la revendication 1, caractérisé en ce que le film est généré à l'aide d'un instrument mécanique.

3. Procédé selon la revendication 1 ou la revendication 2, caractérisé en ce que l'acide chlorhydrique est un constituant supplémentaire de l'agent nettoyant.
